# EUROPEAN PATENT APPLICATION

(11) **EP 4 564 404 A1**
(43) Date of publication of application: **04.06.2025**
(21) Application number: 23213742.2
(22) Date of filing: 01.12.2023
(51) Int. Cl.: H01L 21/311, H01L 21/02, H01L 21/683

(54) **A METHOD FOR REMOVING RESIDUES FROM A SUBSTRATE SURFACE**

(71) Applicant: Imec VZW, 3001 Leuven (BE)
(72) Inventor: Altamirano Sanchez, Efrain, 3010 Kessel-Lo (BE); Le, Quoc Toan, 5001 Belgrade (BE)
(74) Representative: Patent Department IMEC

(57) **Abstract**

A temporary polymer layer (16) required on a substrate (1) in a semiconductor processing sequence is produced on an auxiliary layer (15) produced on the substrate prior to forming the temporary polymer layer. The auxiliary layer (15) is removable from the surface of the substrate essentially without leaving residues on said surface. The polymer layer (16) and the auxiliary layer (15) are removed after a number of processing steps performed on the substrate. The removal of the polymer layer (16) may leave residue on the auxiliary layer (15), but removing the latter leaves the surface essentially residue-free. The invention thereby enables the removal of temporary bonding material from a hybrid bonding surface without leaving polymer residue, so that the appearance of voids during hybrid bonding is avoided. The invention is however applicable also to the formation of other temporary polymer layers, such as a photoresist layer and a protective layer for singulation.

## Description

### Field of the Invention

The present invention is related to semiconductor processing, and in particular to cleaning steps applied at various stages during a semiconductor fabrication process.

### State of the art.

Semiconductor processing utilizes different types of polymers. Two applications of polymer layers are their use as photoresists (PR) layers, primarily deep ultraviolet (DUV) photoresist layers, and layers of temporary bonding material (TBM). The nature and thickness of such polymer layers varies depending on the types of DUV PRs, ranging from 1 µm to about 150 µm in thickness and TBMs, either thermoplastic or elastomer types with thicknesses ranging from 1 µm to about 100 µm. These polymers may be coated on target 300 mm wafers for different purposes: lithography, temporary bonding between target and carrier wafers, protective layers for singulation, etc. Such polymers are sacrificial and must be stripped before performing subsequent steps, for example before hybrid bonding between metal-metal (e.g. Cu-Cu, Al-Al) and dielectric-dielectric (e.g. SiO₂-SiO₂, SiCN-SiCN, SiN-SiN). The stripping of such polymers is carried out using one or more organic solvents or aqueous chemicals, but polymer residues are likely to remain on the surface after these stripping procedures. When such residues remain on a bonding surface for hybrid bonding or direct dielectric-to-dielectric bonding for example, they can be responsible for the creation of micro-voids in the bonding region.

Such residues are however very difficult to remove without attacking the surface. For example when the surface is a hybrid bonding surface, comprising a dielectric material with metal contact pads coplanar therewith, applicable chemistries for the removal of a temporary bonding layer from such a surface are subject to narrowly defined conditions in order to avoid damage to the metal and/or the dielectric. Under such conditions, it is essentially unavoidable that polymer residue remains on the surface. The stripping of the polymers can also induce a surface modification of the metal that will manifest as corrosion in downstream integration steps.

### Summary of the invention

The invention is related to a method as disclosed in the appended claims. According to the invention, a temporary polymer layer required on a substrate in a semiconductor processing sequence is produced on an auxiliary layer produced on the substrate prior to forming the temporary polymer layer. The auxiliary layer is removable from the surface of the substrate essentially without leaving residues on said surface. The polymer layer and the auxiliary layer are removed after a number of processing steps performed on the substrate. The removal of the polymer layer may leave residue on the auxiliary layer, but removing the latter leaves the surface essentially residue-free. The invention thereby enables the removal of temporary bonding material from a hybrid bonding surface essentially without leaving polymer residue, so that the appearance of voids during hybrid bonding is avoided. The invention is however applicable also to the formation of other temporary polymer layers, such as a photoresist layer and a protective layer for singulation.

The invention is in particular related to a semiconductor processing method comprising a coating step wherein a temporary polymer layer (16) is produced on a substrate (1), and further comprising after said coating step and after executing one or more further processing steps on the substrate, a removal step wherein said temporary layer is removed or wherein parts of said layer are removed which have remained after executing said one or more further processing steps, characterized in that :
- directly prior to the coating step, an auxiliary layer is produced directly on a surface of the substrate, said auxiliary layer being removable from said surface essentially without leaving any residues on said surface,
- the temporary polymer layer is produced directly on the auxiliary layer,
- the removal step comprises :
   ∘ removing the temporary polymer layer or said parts thereof, selectively with respect to the auxiliary layer,
   ∘ removing or essentially removing the auxiliary layer, selectively with respect to said surface of the substrate, resulting in a substantially residue-free substrate surface. The wording 'removing or essentially removing' encompasses both the complete removal of the polymer or the removal of the majority of the polymer with only a small amount remaining, for example in the form of polymer residue.

According to an embodiment, the substrate is a process wafer comprising a die side and a back side and the polymer layer is applied on the die side of the process wafer.

According to an embodiment:
- the process wafer comprises on the die side a plurality of dies which comprise a bonding surface suitable for direct dielectric-to-dielectric or hybrid bonding of said dies to a target substrate,
- the polymer layer is a temporary bonding layer produced on the die side of the process wafer,
- the one or more further processing steps include temporarily bonding the process wafer to a carrier substrate by removably attaching the temporary bonding layer to said carrier substrate, performing processing steps on the back side of the process wafer, and releasing the process wafer from the carrier substrate so that the auxiliary layer and the temporary bonding layer remain on the die side of the process wafer.

According to an embodiment, the bonding surface is suitable for hybrid bonding, comprising metal contact pads embedded in a layer of dielectric material.

According to an embodiment, said metal contacts are Cu contact pads and wherein the layer of dielectric material is a layer of SiCN.
According to an embodiment:
- the polymer layer is a photoresist layer produced on the die side of the process wafer,
- the one or more further processing steps include a lithography step wherein parts of the photoresist layer are removed, and an etching step wherein a pattern defined by said removed parts is transferred to the auxiliary layer thereby removing parts thereof, and to a layer underlying the auxiliary layer,
- the removal step comprises removing or essentially removing the remaining parts of the photoresist layer, followed by removing the remaining parts of the auxiliary layer, thereby leaving the surface of said underlying layer essentially residue-free.

According to an embodiment, the polymer layer is a protective layer for protecting dies processed on the substrate, during singulation of the dies.

According to an embodiment, the auxiliary layer is formed of a material chosen from the group consisting of : titanium nitride, titanium, hafnium nitride, hafnium oxide, titanium oxide, silicon oxide.

According to an embodiment, the polymer layer or said parts thereof is or are removed or essentially removed by applying a solvent to said polymer layer.

According to an embodiment, after removing the polymer layer or said parts thereof selectively with respect to the auxiliary layer, residues of the polymer layer remain on the auxiliary layer.

According to an embodiment, the auxiliary layer is removed by wet etching.

According to an embodiment, the thickness of the auxiliary layer is between 5 nm and 100 nm.

### Brief description of the figures

Figures 1a to 1c illustrate a process wafer and a layout of multiple dies on the wafer.
Figures 2 to 9 illustrate method steps which illustrate an exemplary embodiment of the invention.

### Detailed description of the invention

The invention will be described on the basis of an exemplary embodiment, which is however not limiting the scope of the invention. All references with respect to shapes, dimensions or materials are cited by way of example only.

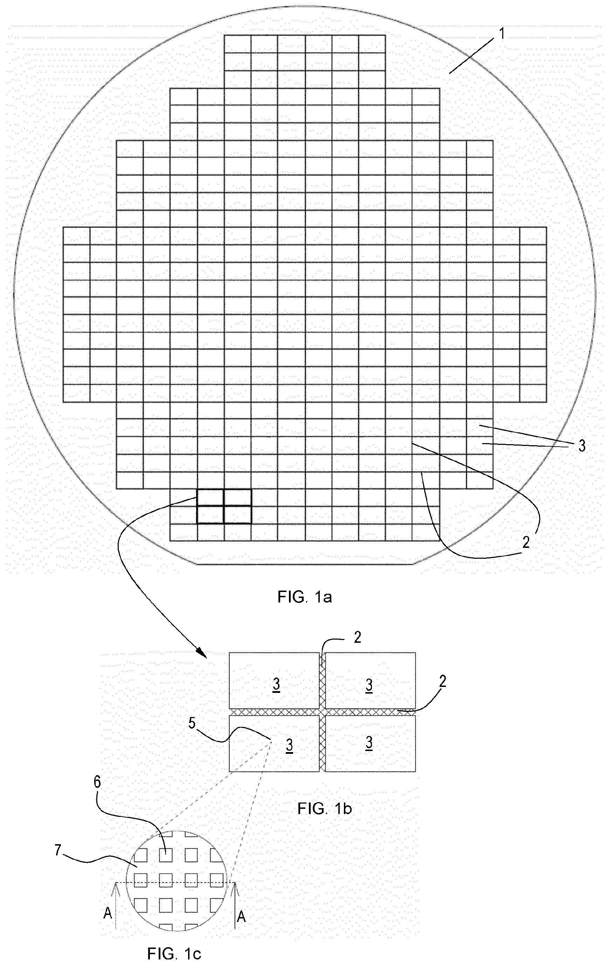

Figure 1a illustrates a process wafer 1 which may be a crystalline silicon wafer as generally known in the art, for example a standard process wafer of 300mm in diameter and having a thickness of a few hundred micrometres. Scribe lines 2 divide the wafer surface into a plurality of die areas on the front side of the wafer, hereafter also referred to as the die side of the wafer. Each die area comprises a semiconductor die 3, which may be an integrated circuit produced according to a given processing sequence, and comprising contacts on its upper surface for electrically connecting the integrated circuit. Four adjacent dies 3 are represented in an enlarged image in Figure 1b. The surface area of each die 3 may be in the order of a few tens of square mm. Details of the front surface of the dies 3 are not shown as these details are not distinguishable on the scale of the image in Figure 1b. The scribe lines 2 are wide enough to enable singulating the finished dies, and may serve also as areas for printing auxiliary features such as metrology marks.

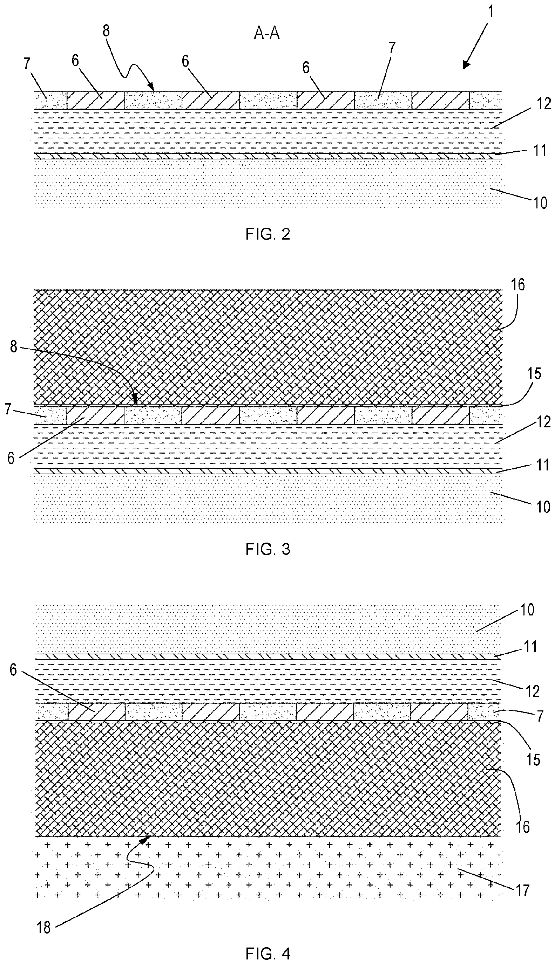

The method of the exemplary embodiment of the invention is explained on the basis of a micrometre-sized section along line A-A in one die 3, as indicated in Figure 1c, which shows an enlargement of a spot 5 in the surface area of said die. In Figure 1c, it is seen that the upper surface of the die is formed by an array of copper contact pads 6 embedded in a dielectric layer 7. The section view along line A-A is represented in a further enlarged view in Figure 2. Only a thin upper portion of the wafer 1 is shown, said portion having a thickness in the order of a few micrometres.

As seen in Figure 2, the die 3 is an integrated circuit die comprising a bulk Si part 10, a front end of line (FEOL) part 11 comprising active devices such as transistors or diodes, and a back end of line (BEOL) part 12 which is a multilevel structure of interconnected electrical conductors and vias designed to provide signal routing to the active devices, and embedded in an electrically isolating dielectric material. The Cu contact pads 6 and the dielectric layer 7 are lying on top of the BEOL part 12, with the contact pads 6 electrically connected to the top level of the BEOL part. The dielectric layer 7 is hereafter considered to be a layer of SiCN although other materials are possible, such as silicon oxide. Layer 7 is coplanar with the top surface of the Cu contact pads 6. The coplanar surface of the pads 6 and the layer 7 is referred to hereafter as the bonding surface 8 of the die 3.

In the plane of the wafer 1, the pads 6 have a rectangular cross-section with a width of about 2 µm. The thickness of the pads 6 is less than 1 µm. The distance between adjacent contact pads 6 is of the same order of magnitude as the width of the pads 6. As stated, these shapes and dimensions do not limit the scope of the invention, but are used as examples only.

The pads 6 may be processed by the well-known damascene-type processing technique used for producing BEOL type interconnect structures. Usually, a diffusion barrier (not shown in Figure 2) is present between the contact pads 6 and the dielectric layer 7.

The bonding surface 8 is intended to be bonded to a similar bonding surface of another die by a bonding technique known as hybrid bonding, wherein a direct Cu-Cu bond is formed between corresponding Cu contacts and wherein a direct SiCN-SiCN bond is formed between the respective SiCN layers. Before executing this bonding step however, further processing steps are performed, which include thinning the bulk Si wafer 10 from the back side. To this aim, a layer of temporary bonding material (TBM) is to be coated on the die side of the wafer 1. According to the invention, and as illustrated in Figure 3, the TBM layer is not deposited directly on the bonding surface 8, but an auxiliary layer 15 is deposited first on said bonding surface, followed by the deposition of the TBM layer 16. The TBM layer is typically an organic polymer layer capable of forming a strong temporary bond and removable by a solvent. Elastomers or thermoplastic polymers are suitable materials for this purpose. The thickness of the TBM layer 16 in the exemplary embodiment shown is about 4 µm. Generally this layer may be for example between 1 µm and 100 µm thick as known in the art. The TBM layer may be applied by spin coating the polymer material onto the auxiliary layer 15.

The auxiliary layer 15 may be a layer of TiN for example, but other materials are applicable when applied to a hybrid Cu/SiCN surface, for example titanium, hafnium nitride, titanium oxide, hafnium oxide or silicon oxide. These materials are removable from a Cu/SiCN hybrid surface without substantially attacking the constituent materials (Cu and SiCN) of said hybrid surface. The auxiliary layer 15 may be applied for example by sputter deposition, which is a form of physical vapour deposition (PVD). The thickness of the auxiliary layer 15 may be a few tens of nanometres, preferably between 5 nm and 100 nm.

After applying the stack of layers 15 and 16, the wafer 1 is reversed and bonded face down to a temporary carrier wafer 17, as illustrated in Figure 4, with the TBM layer 16 realizing a temporary adhesive bond along bonding interface 18.

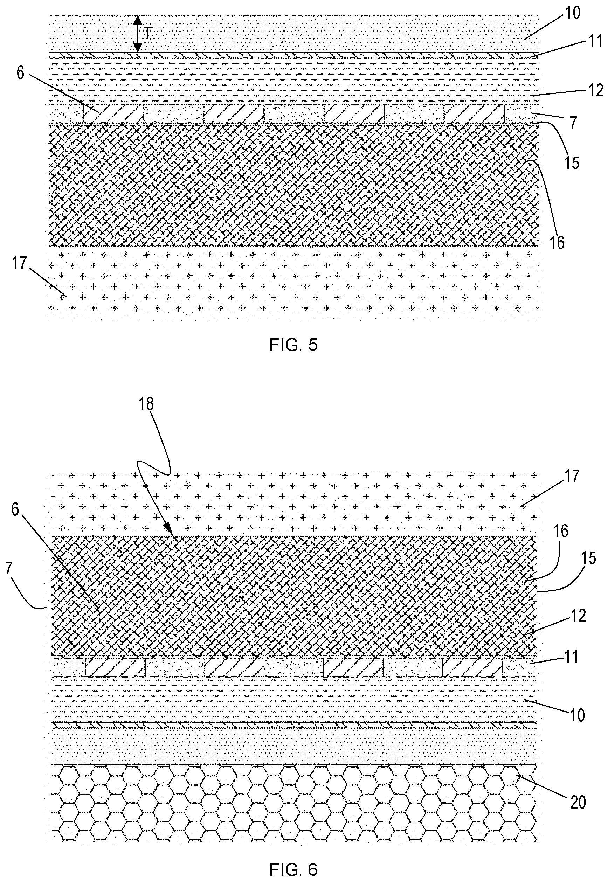

The bulk Si wafer 10 is then thinned from the back side, which may be done by grinding and/or wet etching, until the bulk Si is reduced to a thickness T as shown Figure 5.

With reference to Figure 6, the assembly of the carrier 17 and the process wafer 1 is then reversed and the back side of the thinned Si wafer 10 is bonded to an additional carrier 20 which may be an additional temporary carrier or a permanent carrier, i.e. a carrier to which the thinned wafer is bonded by a non-releasable bond or adhesive. Alternatively, the back side of the Si wafer 10 may be further thinned and subjected to processing steps, for example including the production of through-silicon vias and back side contacts.

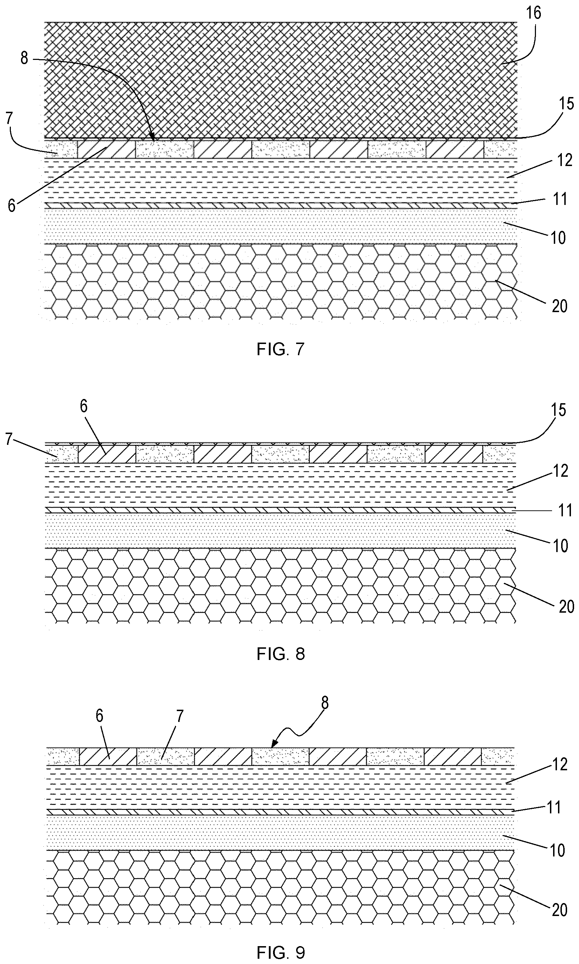

The temporary carrier 17 is then removed by releasing the temporary bond along interface 18, which may for example be done by heating if the TBM layer 16 is formed of a thermoplastic polymer. As shown in Figure 7, the stack of the auxiliary layer 15 and the TBM layer 16 remains on the hybrid bonding surface 8.

Thereafter and with reference to Figure 8, the TBM layer 16 is removed selectively with respect to the underlying auxiliary layer 15. This may be done by a solvent, applied by a technique known as such in the art, for example by submerging the wafer or a batch of wafers in a solvent bath for a given time. Alternatively, on a single wafer, the solvent may be spun onto the wafer surface followed by drying the wafer surface. Depending on the type of solvent and the time allowed for the dissolution of the TBM, residues of the temporary bonding material may or may not remain on the surface of the auxiliary layer 15 after this TBM removal step.

This is followed by the removal of the auxiliary layer 15 as illustrated in Figure 9. In the case of a TiN layer, this may be done by a wet etching step using an aqueous mixture that does not attack Cu nor SiCN. Such mixtures are known as such in the art. Even with TBM residue remaining on the TiN layer 15, this leaves the hybrid bonding surface 8 clean and essentially free of residues.

The provision of the auxiliary layer 15 thereby enables removing the TBM layer 16 essentially without leaving any residue material. The hybrid bonding surface 8 is thereby ideally prepared for a hybrid bonding process to another die or wafer. This may be done in a wafer-to-wafer bonding process or in a die-to-wafer bonding process, after singulating the wafer 1 along the scribe lines 2.

As stated, the invention is not limited to the materials and dimensions referred to with respect to the above-described exemplary embodiment. The method is applicable to any temporary polymer layer applied during a semiconductor production process. This includes for example also polymer photoresist layers applied in a lithographic process. Such a layer is formed of a photosensitive polymer, that is developed after illuminating the layer through a lithographic mask, so that the resist remains in a solid state according to a given pattern. According to the invention, an auxiliary layer is applied before producing the resist layer. After developing the resist, the pattern is then transferred to one or more underlying layers by etching. This removes parts of the auxiliary layer in the areas where the photoresist has been removed, before transferring the pattern to one or more layers underlying the auxiliary layer. The resist is then stripped, in the manner described above for the removal of the TBM layer: by the removal of the resist selectively with respect to the auxiliary layer, followed by the selective removal of the auxiliary layer with respect to the underlying surface. Said surface is thereby left essentially clean and without residue.

Another example of a temporary polymer layer to which the invention is applicable is a protective layer for singulation. Such a layer is applied on the finished dies 3 of a wafer as shown in Figure 1a, prior to dicing the wafer, i.e. separating the dies by sawing or cutting along the scribe lines 2 by other means such as plasma etching. The protective layer needs to be removed after the singulation step, essentially without leaving any residues. When an auxiliary layer is applied prior to applying the protective layer, this auxiliary layer enables removing the protective layer essentially without leaving residues, in the same manner as described above for the TBM and the photoresist layers.

The method is applicable to different types of surfaces from which a temporary polymer layer needs to be removed without leaving residues. The method is for example applicable to a dielectric bonding surface as well as to a hybrid bonding surface, for example to a SiCN surface applicable in a direct SiCN-SiCN bonding process.

A practical example and proof of concept is described hereafter.

A TiN layer of 10 nm thick was deposited on a wafer having a SiCN blanket layer on its surface. The TiN deposition was carried out by sputter deposition. Thereafter a TBM layer of 30 µm thick was spun on the TiN layer. The TBM was BrewerBond^{®} 305 available from supplier Brewer Science. The TBM layer was dissolved using the solvent mesitylene at 40°C during a static dissolution time of 50 min. Thereafter, residues of the TBM material remained on the TiN surface. The TiN layer was removed by wet etching using an aqueous mixture at 55°C during an etch time of 60s. After this, the TiN and the residues were completely removed, leaving a clean SiCN surface.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A semiconductor processing method comprising a coating step wherein a temporary polymer layer (16) is produced on a substrate (1), and further comprising after said coating step and after executing one or more further processing steps on the substrate, a removal step wherein said temporary layer is removed or wherein parts of said layer are removed which have remained after executing said one or more further processing steps,
**characterized in that** :
- directly prior to the coating step, an auxiliary layer (15) is produced directly on a surface (8) of the substrate, said auxiliary layer being removable from said surface (8) essentially without leaving any residues on said surface (8),
- the temporary polymer layer (16) is produced directly on the auxiliary layer (15),
- the removal step comprises :
∘ removing or essentially removing the temporary polymer layer (16) or said parts thereof, selectively with respect to the auxiliary layer (15)
∘ removing the auxiliary layer (15), selectively with respect to said surface (8) of the substrate, resulting in a substantially residue-free substrate surface (8).

2. The method according to claim 1, wherein :
- the substrate is a process wafer (1) comprising a die side and a back side,
- the polymer layer (16) is applied on the die side of the process wafer (1).

3. The method according to claim 2, wherein :
- the process wafer (1) comprises on the die side a plurality of dies (3) which comprise a bonding surface (8) suitable for direct dielectric-to-dielectric or hybrid bonding of said dies to a target substrate,
- the polymer layer is a temporary bonding layer (16) produced on the die side of the process wafer (1),
- the one or more further processing steps include temporarily bonding the process wafer to a carrier substrate (17) by removably attaching the temporary bonding layer (16) to said carrier substrate (17), performing processing steps on the back side of the process wafer (1), and releasing the process wafer from the carrier substrate (17) so that the auxiliary layer (15) and the temporary bonding layer (16) remain on the die side of the process wafer (1).

4. The method according to claim 3, wherein the bonding surface (8) is suitable for hybrid bonding, comprising metal contact pads (6) embedded in a layer (7) of dielectric material.

5. The method according to claim 4, wherein said metal contacts (6) are Cu contact pads and wherein the layer (7) of dielectric material is a layer of SiCN.

6. The method according to claim 2, wherein :
- the polymer layer (16) is a photoresist layer produced on the die side of the process wafer (1),
- the one or more further processing steps include a lithography step wherein parts of the photoresist layer (16) are removed, and an etching step wherein a pattern defined by said removed parts is transferred to the auxiliary layer (15) thereby removing parts thereof, and to a layer underlying the auxiliary layer (15),
- the removal step comprises removing or essentially removing the remaining parts of the photoresist layer (16), followed by removing the remaining parts of the auxiliary layer (15), thereby leaving the surface of said underlying layer essentially residue-free.

7. The method according to claim 2, wherein the polymer layer (16) is a protective layer for protecting dies (3) processed on the substrate (1), during singulation of the dies.

8. The method according to any one of the preceding claims, wherein the auxiliary layer (15) is formed of a material chosen from the group consisting of : titanium nitride, titanium, hafnium nitride, hafnium oxide, titanium oxide, silicon oxide.

9. The method according to any one of the preceding claims, wherein the polymer layer (16) or said parts thereof is or are removed or essentially removed by applying a solvent to said polymer layer.

10. The method according to any one of the preceding claims, wherein after removing the polymer layer (16) selectively with respect to the auxiliary layer (15), residues of the polymer layer (16) remain on the auxiliary layer (15).

11. The method according to any one of the preceding claims, wherein the auxiliary layer (15) is removed by wet etching.

12. The method according to any one of the preceding claims, wherein the thickness of the auxiliary layer (15) is between 5 nm and 100 nm.
